# EUROPEAN PATENT APPLICATION

(11) **EP 2 784 141 A2**
(43) Date of publication of application: **01.10.2014**
(21) Application number: 14161541.9
(22) Date of filing: 25.03.2014
(51) Int. Cl.: C09J 9/02, H01L 21/60, H01L 23/485

(54) **Anisotropic conductive film and method of making conductive connection**

(30) Priority: 26.03.2013 JP 2013064063
(71) Applicant: FUJIFILM Corporation, Minato-ku Tokyo 106-8620 (JP)
(72) Inventor: Kawashima, Takeaki, Kanagawa, 258-8577 (JP)
(74) Representative: HOFFMANN EITLE

(57) **Abstract**

An anisotropic conductive film (100, 110, 120, 130, 140, 150, 160, 170) includes: an insulation region (102, 122, 132, 142, 12, 162, 172) having a planer shape and containing an insulating filler at a first content rate; and a plurality of conductive particle holding regions (104, 124, 134, 144, 154, 164, 174) arranged in the insulation region, the conductive particle holding regions holding conductive particles (106) and containing the insulating filler at a second content rate lower than the first content rate, the conductive particle holding regions being arranged discretely in a planar direction of the insulation region. A method of making conductive connection between a first terminal arranged on a first member and a second terminal arranged on a second member includes: temporarily tacking the anisotropic conductive film to the first member; holding the first and second members such that the first and second terminals face to each other across the temporarily tacked anisotropic conductive film; pressing the first and second members to each other; and heating the anisotropic conductive film.

## Description

### BACKGROUND OF THE INVENTION

### Field of the Invention

The present invention relates to an anisotropic conductive film and a method of making conductive connection, more particularly to a technique of improving reliability of conductive connection.

### Description of the Related Art

Soldering or metal bonding with gold or copper is generally used as a method of mounting an integrated circuit (IC) on a substrate such as a glass substrate or a flexible printed circuit (FPC). However, in recent years, materials called an anisotropic conductive film (ACF) in the form of a film and an anisotropic conductive paste (ACP) in the form of a paste, which are made of binder resin filled with conductive particles having diameters of several micrometers (µm) at a specific concentration, have started to be popularly used for conductive connection.

For example, according to a mounting process by means of an ACF, the ACF is preliminarily tacked to a substrate, and a heated IC is pressed onto the ACF. At this time, parts of the binder resin of the ACF are at temperatures over the glass transition point, have increased fluidity, and flow onto concavities and convexities on the IC.

Thus, upon mounting by means of the anisotropic conductive material, the conductive particles trapped between bumps on the IC and pads on the substrate provide electrical interconnection, and the binder resin provides mechanical interconnection. That is, this mounting provides electrical connection along with the advantage of enabling the same effect as that of a conventional underfill.

However, there is a problem that the conductive particles also flow out from between the bumps and the pads in the process of pressing the IC against the substrate. When the number of conductive particles flowing out to other than between the bumps and the pads increases, local electric field concentration on these particles causes insulation breakdown in the binder resin and causes a decrease of withstand voltage characteristics.

Further, the binder resin contributing to structural bond is designed mainly focusing on the fluidity of conductive particles, and it is therefore difficult to use a resin that is advantageous for structural bond or a resin having good moisture resistance.

In response to these problems, Japanese Patent Application Publication No. 2003-208820 discloses an anisotropic conductive film including an insulating film member through which conduction paths isolated from each other are formed, and more particularly that a porous film made of heat resistant resin impregnated with an adhesive resin component is used as the insulating film member. According to this technique, upon bonding under heat and pressure, the conduction paths are hardly moved, inclined or deformed and do not short-circuit adjacent terminals. As a result, it is possible to improve conductive connection reliability.

### SUMMARY OF THE INVENTION

It has been reported that, according to a connecting method by means of an anisotropic conductive material, when pitches of pads on a substrate or bumps on an IC are a certain pitch or narrower, local electric field concentration on conductive particles which do not contribute to conductive connection causes insulation breakdown in binder resin and thereby significantly lowers conductive connection reliability.

Moreover, the technique in Japanese Patent Application Publication No. 2003-208820 involves a problem that it is difficult to make a base material that adopts a sponge structure for narrow pitches, and further involves a problem that it is not possible to provide a sufficient mechanical connection strength in recent narrow pitch connection because an application amount of the adhesive is limited.

The present invention has been contrived in view of these circumstances, an object thereof being to provide an anisotropic conductive film and a method of making conductive connection which can provide reliable connection.

In order to attain the aforementioned object, the present invention is directed to an anisotropic conductive film, comprising: an insulation region having a planer shape and containing an insulating filler at a first content rate; and a plurality of conductive particle holding regions arranged in the insulation region, the conductive particle holding regions holding conductive particles and containing the insulating filler at a second content rate lower than the first content rate, the conductive particle holding regions being arranged discretely in a planar direction of the insulation region.

According to this aspect of the present invention, the insulation region containing the insulating filler at the first content rate is formed in the planar shape, and the conductive particle holding regions containing the conductive particles and the insulating filler at the second content rate lower than the first content rate are arranged in the insulation region discretely in the planar direction of the insulation region, so that it is possible to provide reliable connection.

That is, the distribution of the conductive particles can be arbitrarily controlled, so that it is possible to use a resin that is advantageous for structural bond or a resin having good moisture resistance for the insulation region and improve the bonding strength or moisture resistance. Further, only the conductive particles which are necessary and sufficient for conductive connection are held in each of the conductive particle holding regions, so that it is possible to improve insulation characteristics and withstand voltage characteristics.

Preferably, the anisotropic conductive film is arranged between a first member provided with a first terminal and a second member provided with a second terminal and is compressed in a thickness direction of the insulation region to bond the first member and the second member through the insulation region and to electrically connect the first terminal and the second terminal through the conductive particles. According to this aspect of the present invention, it is possible to adequately bond the first member and the second member.

Preferably, the insulation region has a viscosity higher than a viscosity of the conductive particle holding regions. According to this aspect of the present invention, it is possible to prevent the conductive particles held in the conductive particle holding regions from flowing out to the insulation region.

Preferably, the insulation region includes a structural adhesive. More preferably, the structural adhesive uses a thermal cross-linking reaction. According to these aspects of the present invention, it is possible to provide a sufficient bonding strength.

Preferably, each of the conductive particle holding regions has a variation of a content rate of the conductive particles along a thickness direction of the insulation region. More preferably, in each of the conductive particle holding regions, the content rate of the conductive particles on a bottom side is higher than the content rate of the conductive particles on a top side. According to these aspects of the present invention, it is possible to prevent the conductive particles held in the conductive particle holding regions from flowing out to the insulation region.

Preferably, each of the conductive particle holding regions has an exposed surface in at least one of a top surface and a bottom surface of the insulation region. According to this aspect of the present invention, it is possible to provide reliable conductive connection.

Preferably, each of the conductive particle holding regions has one of a columnar shape, a circular truncated cone shape, a conical shape, a spool shape, a semispherical shape and a truncated spherical shape, of which a base is the exposed surface. According to this aspect of the present invention, it is possible to provide reliable conductive connection.

Preferably, each of the conductive particle holding regions contains the conductive particles at a concentration of 30000 particles/mm² to 60000 particles/mm². Consequently, it is possible to provide reliable conductive connection.

Preferably, each of the conductive particles consists of metal or has a core-shell structure of a resin nucleus covered with metal. According to these aspects of the present invention, it is possible to provide reliable conductive connection.

Preferably, the insulating filler includes silica. According to this aspect of the present invention, it is possible to improve moisture resistance.

Preferably, the conductive particle holding regions are arranged at a fixed pitch along an X direction and a Y direction perpendicular to the X direction, the X direction and the Y direction being parallel to the planar direction of the insulation region. According to this aspect of the present invention, the anisotropic conductive film can be used irrespectively of pitches between the terminals of a mounting substrate or an IC.

In order to attain the aforementioned object, the present invention is also directed to a method of making conductive connection between a first terminal arranged on a first member and a second terminal arranged on a second member, the method comprising the steps of: preliminarily tacking the above-described anisotropic conductive film to the first member; then holding the first member and the second member such that the first terminal and the second terminal face to each other across the preliminarily tacked anisotropic conductive film; then pressing the first member and the second member to each other; and then heating the anisotropic conductive film.

According to this aspect of the present invention, the anisotropic conductive film is preliminarily tacked to the first member provided with the first terminal, the first member to which the anisotropic conductive film is preliminarily tacked and the second member are held such that the first terminal and the second terminal face to each other across the preliminarily tacked anisotropic conductive film, the first member and the second member are pressed to each other, and the anisotropic conductive film is heated, so that it is possible to provide reliable connection.

According to this aspect of the present invention, it is possible to provide reliable connection.

### BRIEF DESCRIPTION OF THE DRAWINGS

The nature of this invention, as well as other objects and advantages thereof, will be explained in the following with reference to the accompanying drawings, in which like reference characters designate the same or similar parts throughout the figures and wherein:
Figs. 1A and 1B are schematic drawings illustrating a mounting method by means of a conventional anisotropic conductive material;
Fig. 2 is a block diagram illustrating a configuration of a mounting apparatus;
Figs. 3A to 3C are views illustrating an ACF according to a first embodiment of the present invention;
Fig. 4 is a view illustrating a configuration of a conductive particle;
Figs. 5A and 5B are schematic diagrams illustrating a mounting method by means of the ACF according to the first embodiment;
Fig. 6 is a view illustrating another aspect of an arrangement pitch of the conductive particle holding parts;
Figs. 7A to 7D are enlarged cross-sectional views illustrating modified embodiments of the ACFs;
Fig. 8 is a flowchart of a manufacturing method of the ACF shown in Fig. 7D;
Figs. 9A to 9E are cross-sectional views for explaining some steps of the manufacturing method in Fig. 8;
Figs. 10A to 10C are enlarged cross-sectional views illustrating ACFs according to a second embodiment of the present invention;
Fig. 11 is a flowchart of a manufacturing method of the ACF shown in Fig. 10A;
Figs. 12A to 12E are cross-sectional views for explaining some steps of the manufacturing method in Fig. 11;
Fig. 13 is a flowchart of a manufacturing method of the ACF shown in Fig. 10B;
Figs. 14A to 14E are cross-sectional views for explaining some steps of the manufacturing method in Fig. 13;
Fig. 15 is a flowchart of a manufacturing method of the ACF shown in Fig. 10C; and
Figs. 16A to 16E are cross-sectional views for explaining some steps of the manufacturing method in Fig. 15.

### DETAILED DESCRIPTION OF THE PREFERRED EMBODIMENTS

### Mounting with Conventional Anisotropic Conductive Material

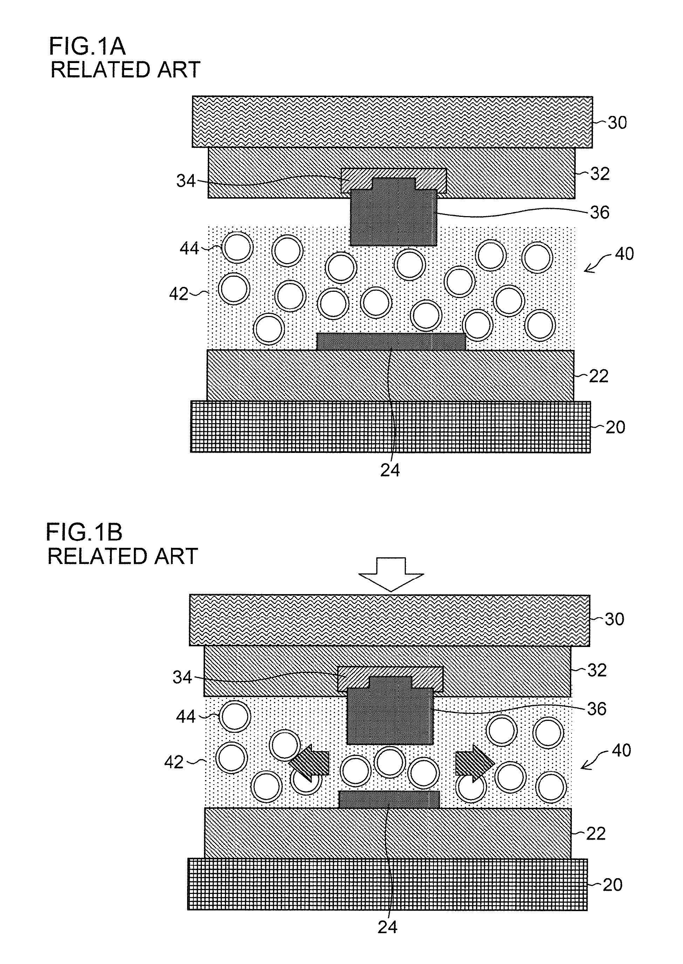

Figs. 1A and 1B are schematic drawings illustrating a mounting method by means of a conventional anisotropic conductive material. A mounting apparatus has a table unit 20, on which a mounting target member is placed, and a holding unit 30, which holds a mounting member. Here, an example is described where an integrated circuit (IC) 32 is mounted on a mounting substrate 22 through an anisotropic conductive film (ACF) 40, and a pad terminal 24 arranged on the mounting substrate 22 and a bump 36 formed on a pad terminal 34 arranged on the IC 32 are electrically connected to each other.

In the mounting apparatus, the mounting substrate 22 is placed on the table unit 20 and the IC 32 is held in the holding unit 30 such that the pad terminal 24 and the bump 36 face to each other. The ACF 40 is preliminarily tacked to the mounting substrate 22 as shown in Fig. 1A. The ACF 40 is formed of binder resin 42 filled with minute spherical conductive particles 44 and is in the shape of tape.

As shown in Fig. 1B, the mounting apparatus then presses the holding unit 30 toward the fixed table unit 20 using a pressing unit (not shown), and thereby the ACF 40 is applied with pressure. When the mounting substrate 22 and the IC 32 are pressed to each other, the binder resin 42 of the ACF 40 is compressed and the conductive particles 44 are trapped between the pad terminal 24 and the bump 36. Thereby, the pad terminal 24 and the bump 36 are electrically interconnected through the trapped conductive particles. By heating the holding unit 30 with a heating unit (not shown) and curing the binder resin 42 in this state, the IC 32 is mechanically bonded to the mounting substrate 22 (bonded under heat and pressure).

Here, there is a problem that when the IC 32 is pressed onto the mounting substrate 22 as shown in Fig. 1B, the conductive particles 44 flow out from between the pad terminal 24 and the bump 36, and the conductive particles 44 trapped between the pad terminal 24 and the bump 36 decrease.

### First Embodiment

### <Configuration of Mounting Apparatus>

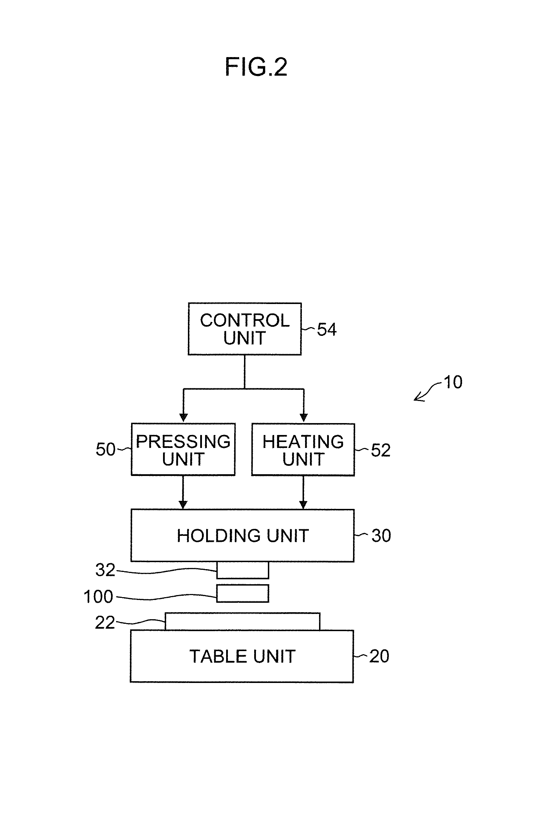

Fig. 2 is a block diagram illustrating a configuration of a mounting apparatus 10 according to the present embodiment. As shown in Fig. 2, the mounting apparatus 10 includes a table unit 20, a holding unit 30, a pressing unit 50, a heating unit 52, a control unit 54 and the like.

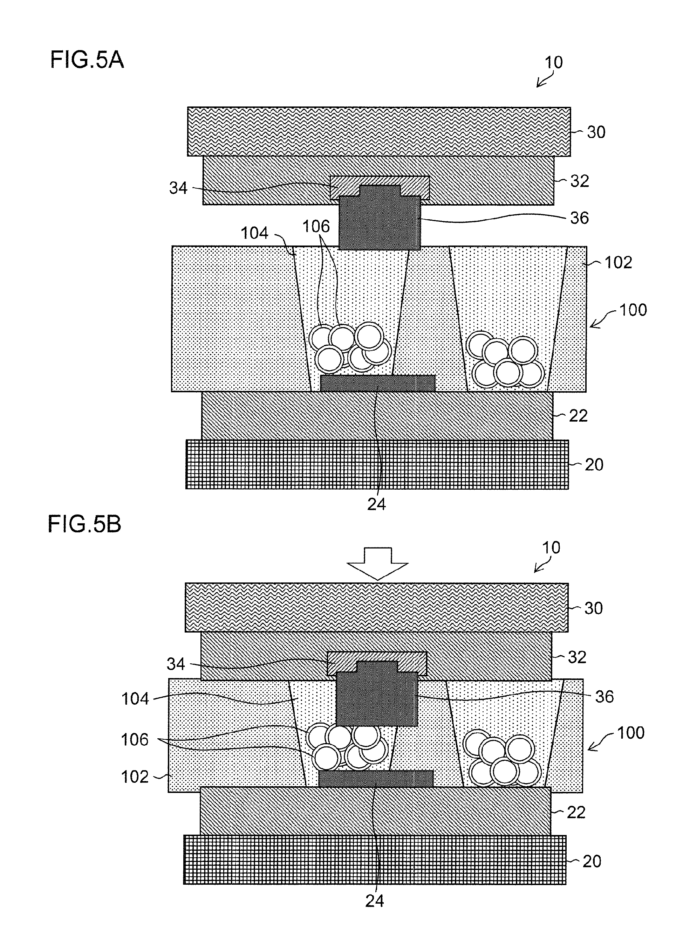

The table unit 20 is fixed to a predetermined position, and a mounting substrate 22 is placed thereon. A mounting surface of the mounting substrate 22 is provided with pad terminals 24 (see Figs. 5A and 5B). An ACF 100 described later is preliminarily tacked the mounting surface of the mounting substrate 22.

The holding unit 30 holds an IC 32. The IC 32 is provided with pad terminals 34, on which bumps 36 are respectively formed (see Figs. 5A and 5B). The holding unit 30 holds the IC 32 such that the surface of the IC 32 on which the pad terminals 34 are arranged faces downward, and the pad terminals 24 and the pad terminals 34 (the bumps 36), which are to be conductively interconnected, face to each other across the ACF 100.

The pressing unit 50 presses the holding unit 30 holding the IC 32 toward the table unit 20. The heating unit 52 heats the ACF 100 through the IC 32 by heating the holding unit 30. The ACF 100 is thereby bonded to the IC 32 under heat and pressure.

The control unit 54 controls a pressing speed of the pressing unit 50 (i.e., a pressing speed of the holding unit 30) and a heating temperature of the heating unit 52.

Although the pressing unit 50 presses the holding unit 30 holding the IC 32 toward the table unit 20 in the present embodiment, the present embodiment is not limited to this configuration and the pressing only needs to be performed such that the mounting substrate 22 and the IC 32 relatively come close to each other. That is, the table unit 20 on which the mounting substrate 22 is placed can be moved toward the holding unit 30 in a state where the holding unit 30 is fixed, or both the table unit 20 and the holding unit 30 can be moved toward each other.

### <Configuration of Anisotropic Conductive Film>

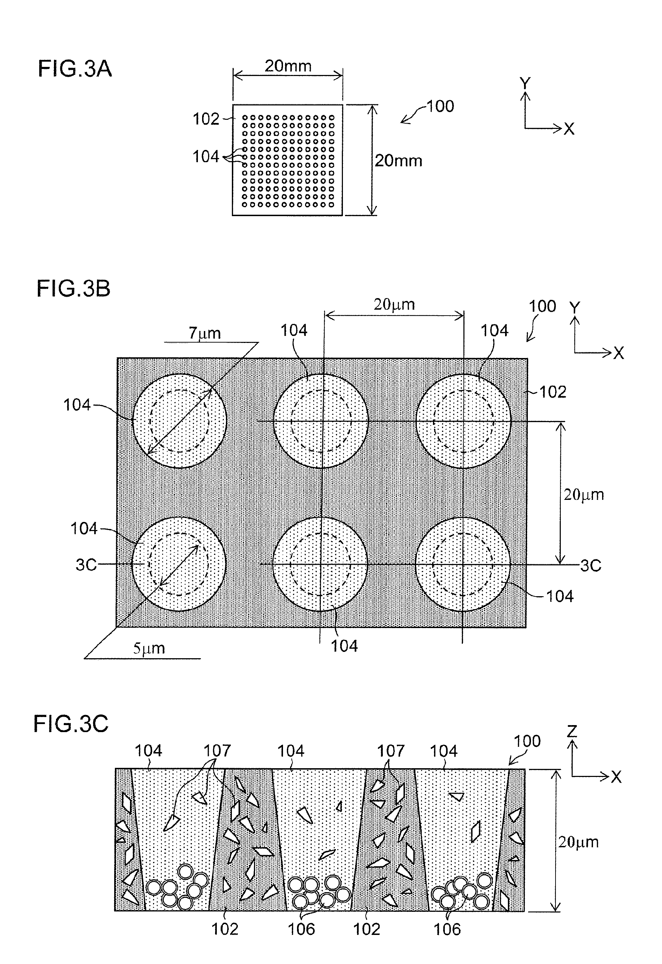

Fig. 3A is a top view of the ACF 100 (an example of an anisotropic conductive film) according to the present embodiment, Fig. 3B is an enlarged view of part of the ACF 100, and Fig. 3C is a cross-sectional view along line 3C-3C in Fig. 3B. As illustrated in Figs. 3A, 3B and 3C, the ACF 100 includes a structural adhesive part 102 (an example of an insulation region), which is formed in a planar surface shape (an example of a planar shape) as a base material, and conductive particle holding parts 104 (an example of a conductive particle holding region formed in the insulation region), which are discretely arranged along a planar direction of the ACF 100 and are formed along a thickness direction of the ACF 100. The ACF 100 is a thin sheet member, and can be easily bent. Although the shape of the ACF 100 is expressed as the planar surface shape, this expression by no means excludes a shape bent in a curved surface shape.

The structural adhesive part 102 has an insulating property. In the present embodiment, the structural adhesive part 102 has a size of 20 mm in an X direction and 20 mm in a Y direction perpendicular to the X direction, and has the thickness of 20 µm in the thickness direction (Z direction) perpendicular to the X direction and the Y direction.

The conductive particle holding parts 104 are discretely arranged in the structural adhesive part 102 at fixed pitches along the X direction and the Y direction. In the present embodiment, the conductive particle holding parts 104 are arranged at the fixed pitch of 20 µm in the X direction and the fixed pitch of 20 µm in the Y direction.

Each of the conductive particle holding parts 104 has a shape of circular truncated cone, of which a top circular surface has a diameter of 7 µm and a bottom circular surface has a diameter of 5 µm, and the top circular surface and the bottom circular surface are flush with a top surface (an upper side in Fig. 3C) and a bottom surface (a lower side in Fig. 3C) of the structural adhesive part 102, respectively. That is, the top circular surface and the bottom circular surface of the conductive particle holding parts 104 are exposed (opened) in the top surface and the bottom surface of the ACF 100, and the conductive particle holding part 104 has the circular truncated cone shape of which the bases are the exposed surfaces.

The ACF 100 illustrated in Figs. 3A, 3B and 3C is an example, and does not necessarily have the above-described dimensions. For example, the structural adhesive part 102 can have the thickness of 20 µm to 30 µm, the top circular surface of the conductive particle holding part 104 can have the diameter of 5 µm to 10 µm, the bottom circular surface of the conductive particle holding part 104 can have the diameter of 5 µm to 10 µm, and the conductive particle holding parts 104 are arranged at the pitches of 15 µm to 20 µm.

The structural adhesive part 102 is made of a resin composition of which the main component is epoxy resin and which includes a structural adhesive using a thermal cross-linking reaction. The structural adhesive part 102 is formed to have a high thixotropy property and low permeability. The conductive particle holding parts 104 are made of a resin composition of which the main component is epoxy resin and which contains conductive particles 106.

The resin compositions constituting the structural adhesive part 102 and the conductive particle holding parts 104 contain inorganic fillers 107 (an example of an insulating filler) which increase viscosities of the structural adhesive part 102 and the conductive particle holding parts 104 and have the insulating property to improve moisture resistance (hygroscopicity). For example, the structural adhesive part 102 contains silica of 40 wt% to 80 wt%, preferably 50 wt% to 60 wt% (an example of a first content rate), and the conductive particle holding part 104 contains silica of 0 wt% or 5 wt% to 10 wt% (an example of a second content rate). Although silica is used for the fillers 107 in the present embodiment, the fillers 107 are not limited to silica but can be insulating fillers of any oxide of Si, Ti or Zn, and further can be non-inorganic.

The structural adhesive part 102 has the viscosity at 25°C of 100 Pa·s to 5000 Pa·s, and the conductive particle holding part 104 has the viscosity at 25°C of 20 Pa·s to 500 Pa·s, for example. It is preferable that the viscosity of the structural adhesive part 102 is higher than the viscosity of the conductive particle holding part 104.

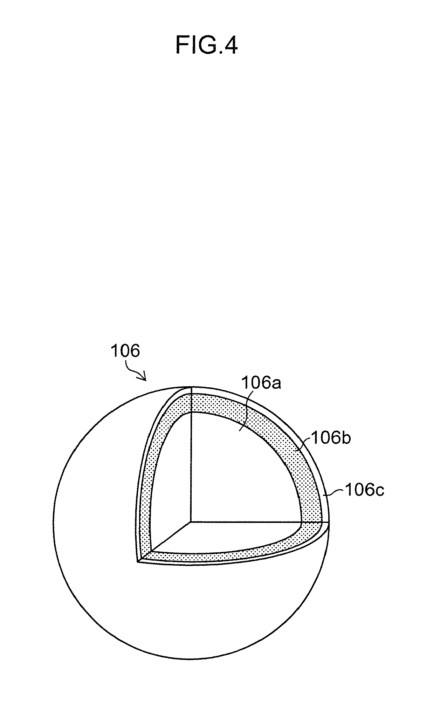

As illustrated in Fig. 4, the conductive particle 106 adopts a core-shell structure constituted of: a core particle 106a (an example of the nucleus of resin), which is made of resin or the like; a metal layer 106b, which covers the core particle 106a and is made of nickel-gold (Ni-Au) alloy or the like; and an insulation layer 106c, which is arranged on the surface of the metal layer 106b and is made of resin or the like.

The configuration of the conductive particles 106 is not limited to the example shown in Fig. 4, and the conductive particles 106 only need to have conductivity and can be particles made of only metal or the like. The diameter of the conductive particle 106 in the present embodiment is 5 µm to 6 µm, for example, and is not limited in particular.

The content rate of the conductive particles 106 in the conductive particle holding parts 104 only needs to ensure that the trapped amount of the conductive particles between the terminals after boding under heat and pressure maintains reliable conductive connection, and is 30000 particles/mm² to 60000 particles/mm² in the present embodiment.

Further, in the present embodiment, the content rate of the conductive particles 106 in each of the conductive particle holding parts 104 varies along the thickness direction (Z direction) of the ACF 100. More specifically, the conductive particle holding part 104 has a lower content rate of the conductive particles 106 on the top side (the upper side in Fig. 3C) of the ACF 100 and a higher content rate of the conductive particles 106 on the bottom side (the lower side in Fig. 3C) of the ACF 100.

### <Mounting through Anisotropic Conductive Material of Present Embodiment>

Figs. 5A and 5B are schematic drawings illustrating a mounting method (an example of a method of making conductive connection) by means of the ACF 100. An example is described where the IC 32 (an example of a second member) is mounted on the mounting substrate 22 (an example of a first member) through the ACF 100, and the pad terminal 24 (an example of a first terminal) and the bump 36 (an example of the second terminal) are electrically connected to each other, similarly to Figs. 1A and 1B.

In the mounting apparatus 10, the mounting substrate 22 is placed on the table unit 20 and the IC 32 is held in the holding unit 30 such that the pad terminal 24 and the bump 36 face to each other (an example of holding process). The ACF 100 is preliminarily tacked to the mounting substrate 22 in a state where the bottom side of the ACF 100, at which the conductive particle holding parts 104 have the higher content rate of the conductive particles 106, is preliminarily adhered to the mounting substrate 22 as shown in Fig. 5A (an example of preliminary tacking process). In this case, at least one of the conductive particle holding parts 104 of the ACF 100 is arranged at a position meeting the pad terminal 24.

As shown in Fig. 5B, the mounting apparatus 10 then presses the holding unit 30 toward the table unit 20 by the pressing unit 50 (an example of pressing process). When the mounting substrate 22 and the IC 32 are pressed to each other, the ACF 100 is compressed, and the conductive particles 106 held in the conductive particle holding part 104 are trapped between the pad terminal 24 and the bump 36. At this time, the conductive particles 106 held in the conductive particle holding part 104 do not flow to the structural adhesive part 102 even when the conductive particle holding part 104 is pressed between the pad terminal 24 and the bump 36, because the structural adhesive part 102 is formed to have the viscosity higher than the viscosity of the conductive particle holding part 104. Hence, the conductive particles 106 are trapped between the pad terminal 24 and the bump 36 while being held in the conductive particle holding part 104. By heating the holding unit 30 with the heating unit 52 and curing the structural adhesive part 102 in this state (an example of heating process), the IC 32 is mechanically bonded to the mounting substrate 22 (bonded under heat and pressure).

Here, the insulation layer 106c formed at the external surface of the conductive particle 106 trapped between the pad terminal 24 and the bump 36 is peeled off by compression bonding, and the metal layer 106b is exposed in the surface of the conductive particle 106. Hence, the pad terminal 24 and the bump 36 are electrically interconnected through the conductive particles 106 trapped between the pad terminal 24 and the bump 36.

On the other hand, in the conductive particle holding parts 104 which do not meet the positions of the pad terminals 24 and the bumps 36, the conductive particles 106 are placed between the mounting substrate 22 and the IC 32 while the insulation layers 106c formed at the external surfaces of the conductive particles 106 are not peeled off and the insulating property is thus kept.

Moreover, the conductive particle holding parts 104 which do not meet the positions of the pad terminals 24 and the bumps 36 are separated from the pad terminals 24 and the bumps 36 by the structural adhesive part 102 having the insulating property, and are placed at positions sufficiently distant from the pad terminals 24 and the bumps 36. Therefore, insulation breakdown is less likely to be caused than a conventional ACF.

Thus, the ACF 100 according to the present embodiment does not suffer insulation breakdown caused by the conductive particles 106 which do not contribute to conductive connection, and can improve insulation characteristics and withstand voltage characteristics and provide reliable narrow pitch connection.

Further, according to the present embodiment, the conductive particle holding parts 104 hold the smaller number of the conductive particles 106 on the top side of the ACF 100 and the larger number of the conductive particles 106 on the bottom side of the ACF 100, so that it is possible to prevent the conductive particles 106 held in the conductive particle holding parts 104 from flowing out to the structural adhesive part 102 upon compression bonding.

Furthermore, according to the present embodiment, the structural adhesive part 102 can be made of the resin that is advantageous for structural bond or the resin having good moisture resistance, and it is possible to improve the bonding strength and moisture resistance. Still further, the resin compositions constituting the structural adhesive part 102 and the conductive particle holding parts 104 contain the inorganic fillers 107, so that the hygroscopicity after curing can be low in comparison with resin compositions which do not contain the fillers 107 and it is possible to improve moisture resistance of the structural bond. Consequently, even when the mounting substrate 22 on which the IC 32 is mounted through the ACF 100 is used in humid environment, the mechanical bond and the electric conduction hardly deteriorate, so that it is possible to improve durability of the structural bond.

### <Modified Embodiments>

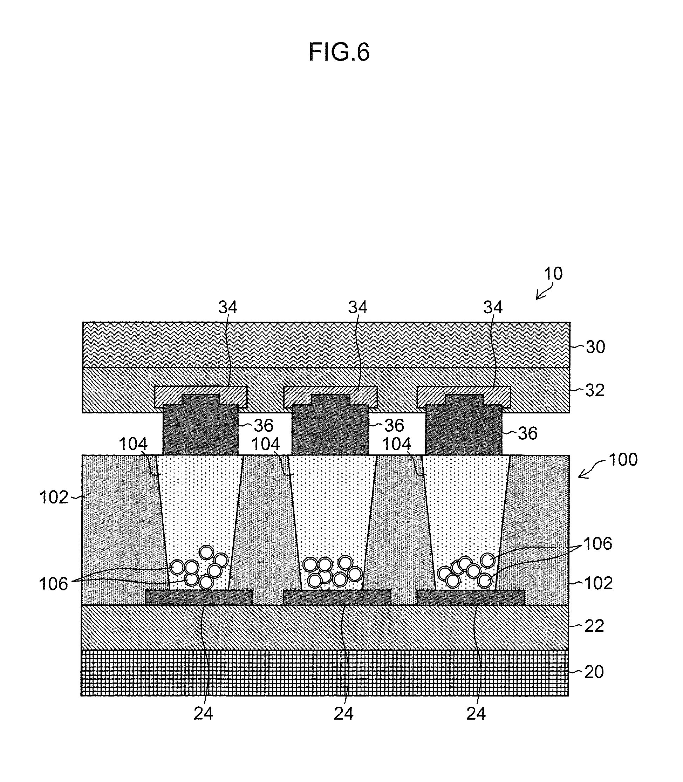

Fig. 6 is a view illustrating a modified embodiment where an arrangement pitch of the pad terminals 24 of the mounting substrate 22 or the pad terminals 34 of the IC 32 and an arrangement pitch of the conductive particle holding parts 104 of the ACF 100 are equal to each other. An aspect that the conductive particle holding parts 104 are arranged in this way is also applicable.

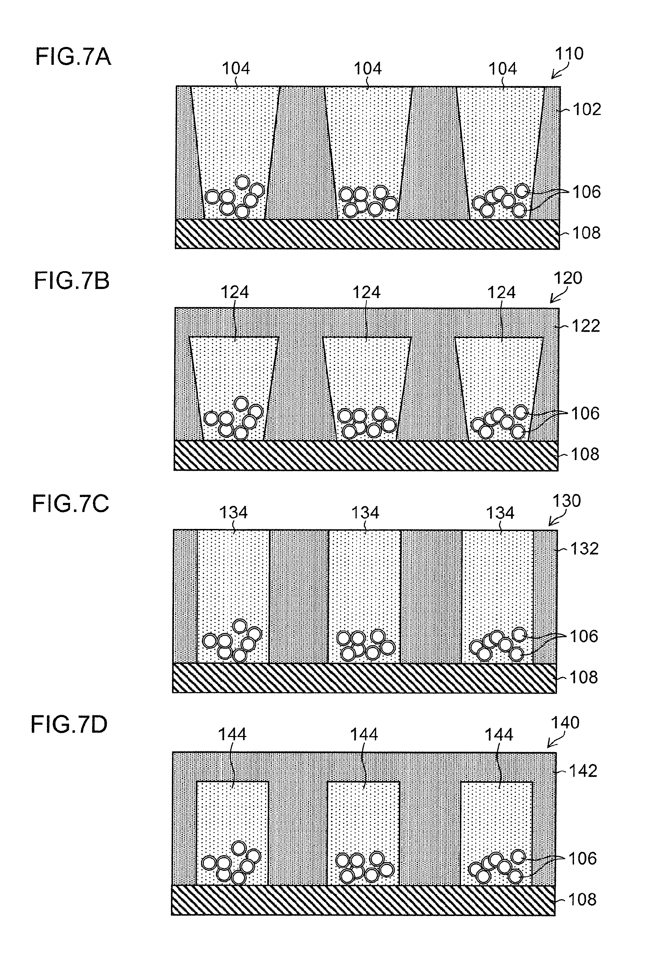

Figs. 7A, 7B, 7C and 7D are enlarged cross-sectional views illustrating modified embodiments of the ACF 100 according to the first embodiment. Here, in comparison with the ACF 100 according to the first embodiment, the resins constituting the structural adhesive part and the conductive particle holding parts, the fillers and the conductive particles are the same, and shapes of the structural adhesive part and the conductive particle holding parts are different.

An ACF 110 illustrated in Fig. 7A is a modification of the ACF 100 provided with a release sheet 108. The release sheet 108 protects the surface of the ACF 110, and is made of a material which can be easily peeled off. By providing the release sheet 108, an operator can easily handle the ACF 110.

In an ACF 120 illustrated in Fig. 7B, each of conductive particle holding parts 124 has a shape of circular truncated cone, and the bottom surfaces of the conductive particle holding parts 124 are exposed in the bottom surface of the ACF 120, whereas the top surfaces of the conductive particle holding parts 124 are not exposed in the top surface of the ACF 120, which is covered with a structural adhesive part 122.

According to the ACF 120, upon compression bonding, the structural adhesive part 122 over the conductive particle holding parts 124 flow to both sides of the bump 36, and the conductive particles 106 held in the conductive particle holding parts 124 are trapped between the pad terminal 24 and the bump 36. Consequently, it is possible to conductively connect the pad terminal 24 and the bump 36 similarly to the ACF 100. The structural adhesive part 122 over the conductive particle holding parts 124 further prevents the conductive particles 106 from flowing toward the structural adhesive part 122 upon compression bonding. Consequently, it is possible to provide reliable narrow pitch connection.

Thus, the conductive particle holding parts only need to be exposed in at least one surface (the surface preliminarily adhered to the mounting substrate 22) of the top surface and the bottom surface of the ACF.

The conductive particle holding parts 104 in Fig. 7A and the conductive particle holding parts 124 in Fig. 7B can have a shape of circular cone not truncated.

In an ACF 130 illustrated in Fig. 7C, conductive particle holding parts 134 are formed in a structural adhesive part 132 to have top circular surfaces and bottom circular surfaces of the same diameter, i.e., the conductive particle holding parts 134 have a shape of circular column. According to this configuration, it is also possible to provide reliable narrow pitch connection similar to the ACF 100.

In an ACF 140 illustrated in Fig. 7D, the top surfaces of conductive particle holding parts 144 formed in a shape of circular column are not exposed in the top surface of the ACF 140, which is covered with a structural adhesive part 142. According to this configuration, it is also possible to provide reliable narrow pitch connection.

### <Manufacturing Method of ACF>

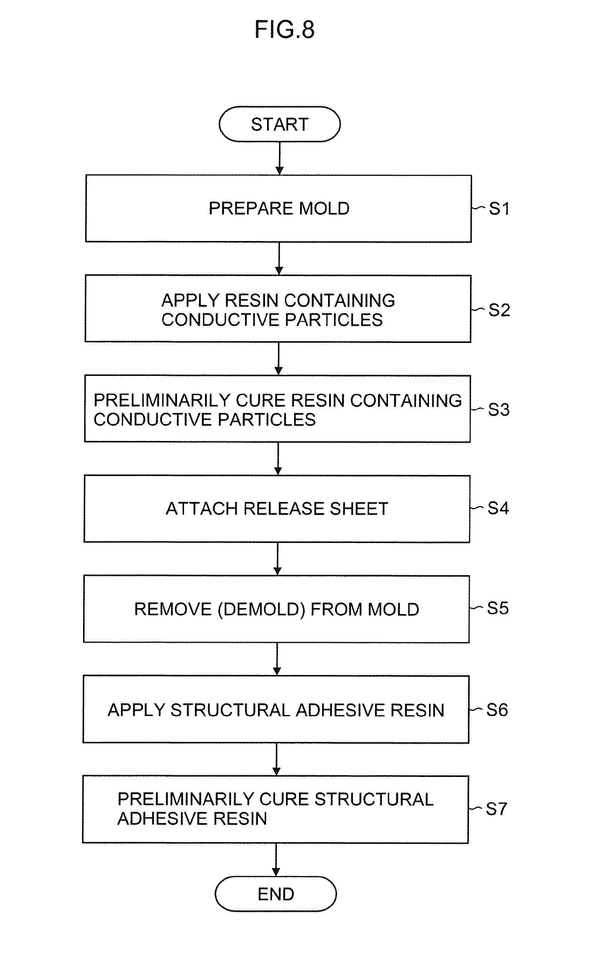

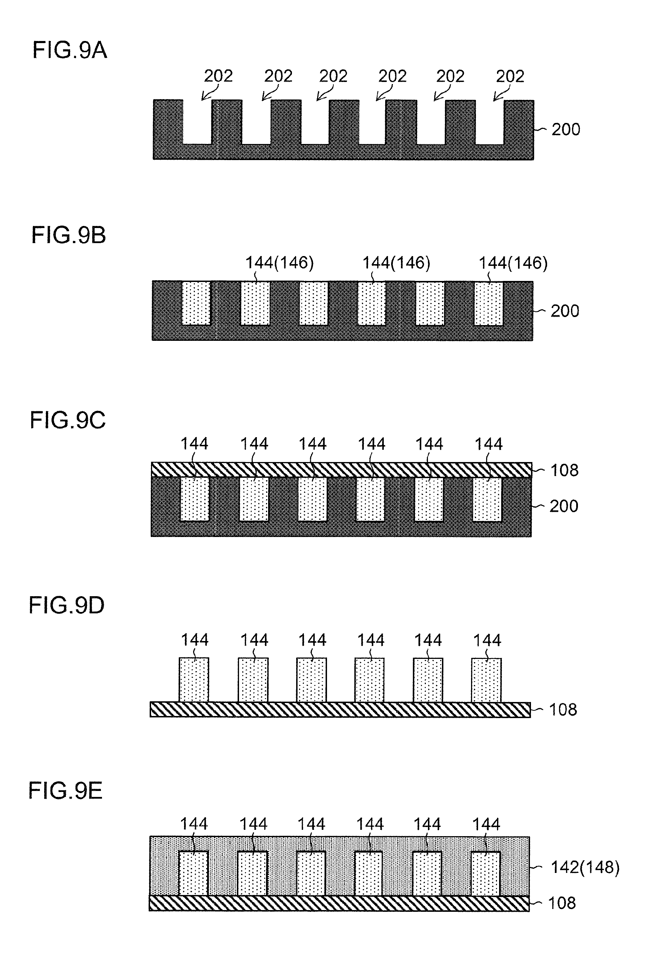

Fig. 8 is a flowchart of a manufacturing method of the ACF 140, and Figs. 9A to 9E are cross-sectional views for explaining some steps in Fig. 8.

### <<Step S1: Preparation of Mold>>

First, a mold 200 is prepared (see Fig. 9A). The mold 200 is used to form the conductive particle holding parts 144, and is formed with cavities 202 of which shape and arrangement are the same as those of the conductive particle holding parts 144.

The mold 200 can be prepared by, for example, forming a mask layer on a base material, patterning the mask layer, etching the base material to a desired depth using the patterned mask layer as a mask and finally removing the mask layer. Although a material of the mold 200 is not limited in particular, nickel, silicon, quartz, glass or the like can be used.

### «Step S2: First Application of Resin Composition»

A resin composition 146 containing the conductive particles is applied on the top surface of the mold 200 (the surface in which the cavities 202 are formed) to fill the resin composition 146 in the cavities 202 of the mold 200. In this case, an adequate amount of the resin composition 146 of which the content rate of the conductive particles is relatively low or zero is filled in the cavities 202 before the resin composition 146 of which the content rate of the conductive particles is relatively high is filled therein, so that it is possible to provide the variation of the content rate of the conductive particles along the thickness direction of the

ACF 140. A method of providing the variation of the content rate of the conductive particles along the thickness direction of the ACF 140 is not limited to this method. For example, the conductive particles can be drawn to one side by means of a magnetic force or an electrostatic force before preliminarily curing the resin composition 146.

### «Step S3: First Preliminary Curing»

The resin composition 146 filled in the cavities 202 of the mold 200 is preliminarily heated and cured. The resin composition 146 having been preliminarily heated and cured forms the conductive particle holding parts 144 (see Fig. 9B).

### «Step S4: Attachment of Release Sheet»

The release sheet 108 is attached to the top surface of the mold 200 (see Fig. 9C).

### «Step S5: Demolding»

The release sheet 108 is peeled off from the mold 200, and the conductive particle holding parts 144 are thereby removed (demolded) from the mold 200. The release sheet 108 having been removed from the mold 200 and inverted from Fig. 9C is illustrated in Fig. 9D, in which the conductive particle holding parts 144 are on the top side of the release sheet 108.

### «Step S6: Second Application of Resin Composition»

A structural adhesive resin composition 148 is applied on the top surfaces of the conductive particle holding parts 144 formed on the release sheet 108.

### «Step S7: Second Preliminary Curing»

Finally, the structural adhesive resin composition 148 is preliminarily heated and cured. The structural adhesive resin composition 148 having been preliminarily heated and cured forms the structural adhesive part 142 (see Fig. 9E).

According to the process as described above, it is possible to manufacture the ACF 140. Consequently, it is possible to easily manufacture fine patterns by means of a usual microfabrication technique.

Further, it is also possible to manufacture the ACFs 110, 120 and 130 illustrated in Figs. 7A, 7B and 7C in the same way by changing the shape of the mold 200 and controlling the application amount of the structural adhesive resin composition in the step S6.

### Second Embodiment

### <Configuration of ACF>

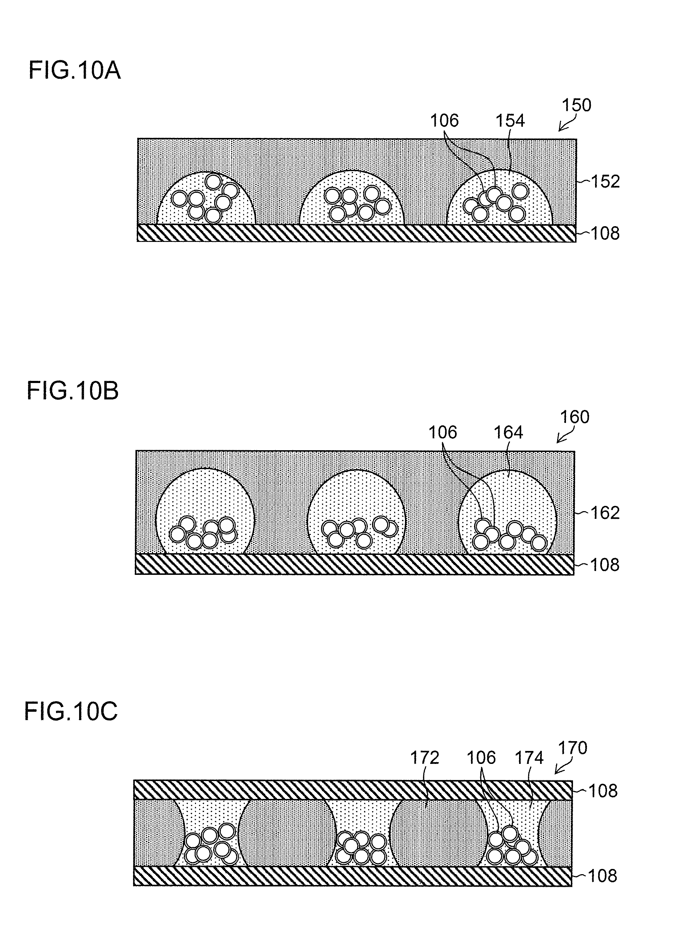

Figs. 10A, 10B and 10C are enlarged cross-sectional views illustrating ACFs according to the second embodiment. Here, in comparison with the ACF 100 according to the first embodiment, the resins constituting the structural adhesive part and the conductive particle holding parts, the fillers and the conductive particles are the same, and shapes of the structural adhesive part and the conductive particle holding parts are different.

In an ACF 150 illustrated in Fig. 10A, each of conductive particle holding parts 154 is formed in a semispherical shape in a structural adhesive part 152, and the bottom surfaces of the conductive particle holding parts 154 are exposed in the bottom surface of the ACF 150, whereas the top surfaces of the conductive particle holding parts 154 are not exposed in the top surface of the ACF 150, which is covered with the structural adhesive part 152.

In an ACF 160 illustrated in Fig. 10B, each of conductive particle holding parts 164 is formed, in a structural adhesive part 162, in a shape of truncated sphere more similar to a sphere than the semispherical shape of the conductive particle holding part 154 of the ACF 150 illustrated in Fig. 10A. Similar to the ACF 150, the bottom circular surfaces of the conductive particle holding parts 164 are exposed in the bottom surface of the ACF 160, whereas the top surfaces of the conductive particle holding parts 164 are not exposed in the top surface of the ACF 160, which is covered with the structural adhesive part 162.

In an ACF 170 illustrated in Fig. 10C, each of conductive particle holding parts 174 is formed, in a structural adhesive part 172, in a shape of spool or pillar having concave sides. The conductive particle holding parts 174 hold a smaller number of the conductive particles 106 on the top side of the ACF 170 and the larger number of the conductive particles 106 on the bottom side of the ACF 170. The top surfaces and the bottom surfaces of the conductive particle holding parts 174 are exposed in the top surface and the bottom surface of the ACF 170. Further, the release sheets 108 are attached to the top surface and the bottom surface of the ACF 170. Similarly, each of the ACFs 100, 110, 120, 130, 140, 150 and 160 can be provided with the release sheets 108 attached to both the top surface and the bottom surface thereof.

The ACFs 150, 160 and 170 can be manufactured by the manufacturing method described with reference to Figs. 8 to 9E. That is, the ACFs 150, 160 and 170 can be manufactured by modifying the shapes of the cavities 202 of the mold 200 into the same shapes as those of the conductive particle holding parts 154, 164 and 174.

### <Manufacturing Method of ACF 150>

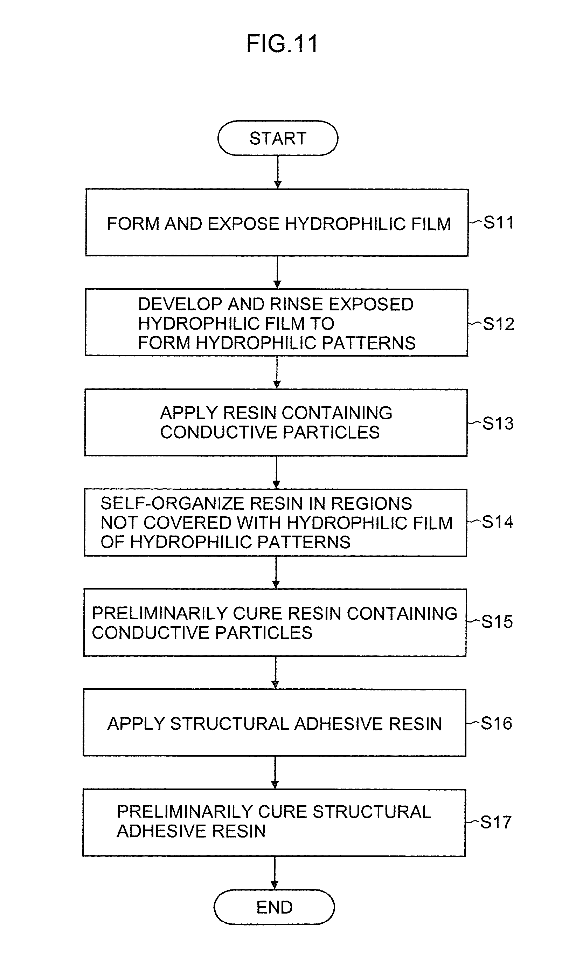

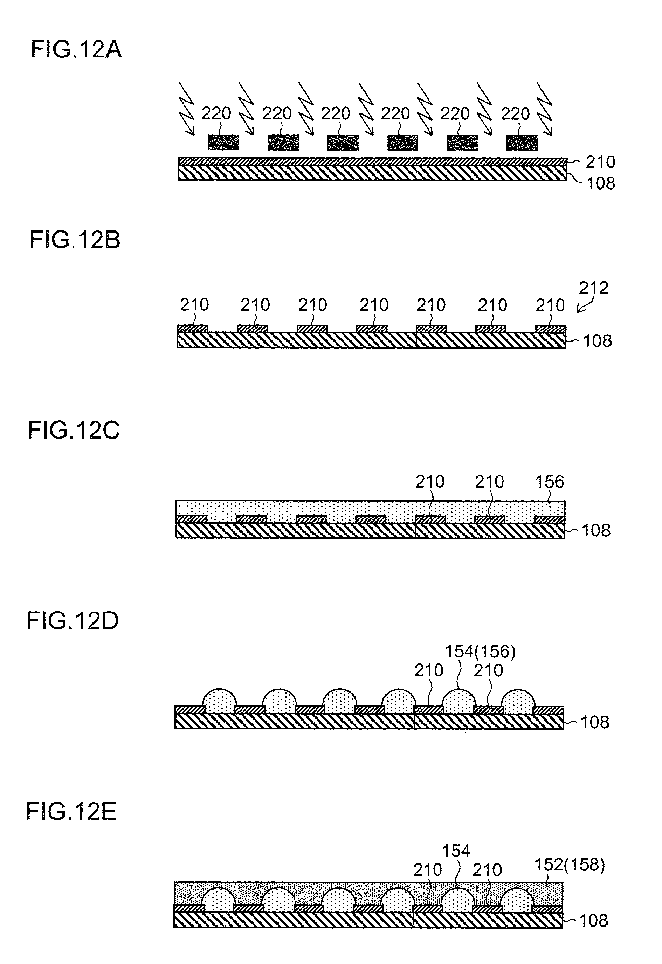

Fig. 11 is a flowchart of a manufacturing method of the ACF 150 illustrated in Fig. 10A, and Figs. 12A to 12E are cross-sectional views for explaining some steps in Fig. 11. Hereinafter, the method of manufacturing the ACF 150 without using the mold 200 is described.

### «Step S11: Formation of Hydrophilic Film»

A hydrophilic material containing a surfactant is applied on the entire surface of the release sheet 108 having the same size as that of the ACF 150 to be manufactured, to form a hydrophilic film 210. Here, a material having the hydrophobic property is used for the release sheet 108.

The hydrophilic film 210 is then irradiated with ultraviolet (UV) light through a mask 220, and patterns on the mask 220 are transferred to the hydrophilic film 210 (see Fig. 12A). The mask 220 has the patterns of UV light blocking parts having the same shapes and the same pitch as those of the bottom surfaces of the conductive particle holding parts 154 to be formed.

### «Step S12: Development»

The hydrophilic film 210 to which the patterns have been transferred in the step S11 is developed and rinsed with pure water. Thereby, parts of the hydrophilic film 210 having been cured by the UV light form hydrophilic patterns 212. The hydrophilic patterns 212 define regions of the top surface of the release sheet 108 which are not covered with the cured hydrophilic film 210 and which have the same shapes and the same pitch as those of the bottom surfaces of the conductive particle holding parts 154 to be formed (see Fig. 12B).

Alternatively, the hydrophilic patterns 212 can be also formed by means of reactive ion etching (RIE).

### «Step S13: First Application of Resin Composition»

A resin composition 156 containing the conductive particles is applied on the top surface of the release sheet 108 on which the hydrophilic patterns 212 have been formed (see Fig. 12C). After the application of the resin composition 156, the conductive particles concentrate toward a lower part due to the gravitational force, so that it is possible to provide the variation of the content rate of the conductive particles along the thickness direction of the ACF 150. Further, in order to provide the variation of the content rate of the conductive particles along the thickness direction of the ACF 150, it is also possible that an adequate amount of the resin composition 156 of which the content rate of the conductive particles is relatively high is applied before the resin composition 156 of which the content rate of the conductive particles is relatively low or zero is applied, or it is also possible to draw the conducive particles downward by means of a magnetic force or an electrostatic force.

### «Step S14: Self-Organization of Resin Composition»

The resin composition 156 having been applied on the top surface of the release sheet 108 self-organizes to form semispherical structures in the regions not covered with the hydrophilic film 210 of the hydrophilic patterns 212.

### «Step S 15: First Preliminary Curing»

The semispherical structures formed by the self-organization of the resin composition 156 are preliminarily heated and cured. The resin composition 156 having been preliminarily heated and cured forms the conductive particle holding parts 154 (see Fig. 12D).

### «Step S16: Second Application of Resin Composition»

A structural adhesive resin composition 158 is applied on the top surfaces of the conductive particle holding parts 154 formed on the release sheet 108.

### «Step S17: Second Preliminary Curing»

Finally, the structural adhesive resin composition 158 is preliminarily heated and cured. The structural adhesive resin composition 158 having been preliminarily heated and cured forms the structural adhesive part 152 (see Fig. 12E).

According to the process as described above, it is possible to manufacture the ACF 150. Consequently, it is possible to easily manufacture fine patterns by means of a usual microfabrication technique including a self-organization technique.

### <Manufacturing Method of ACF 160>

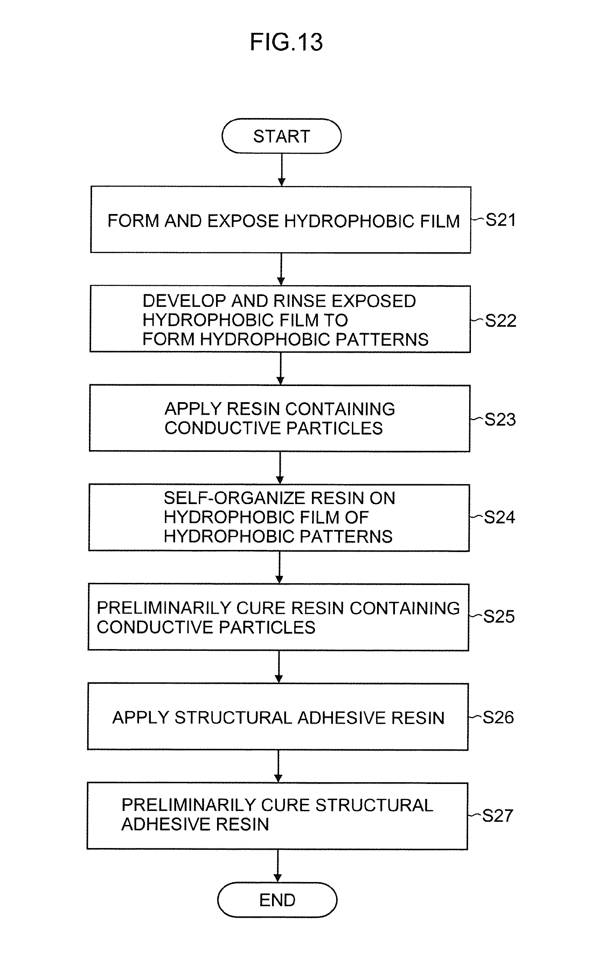

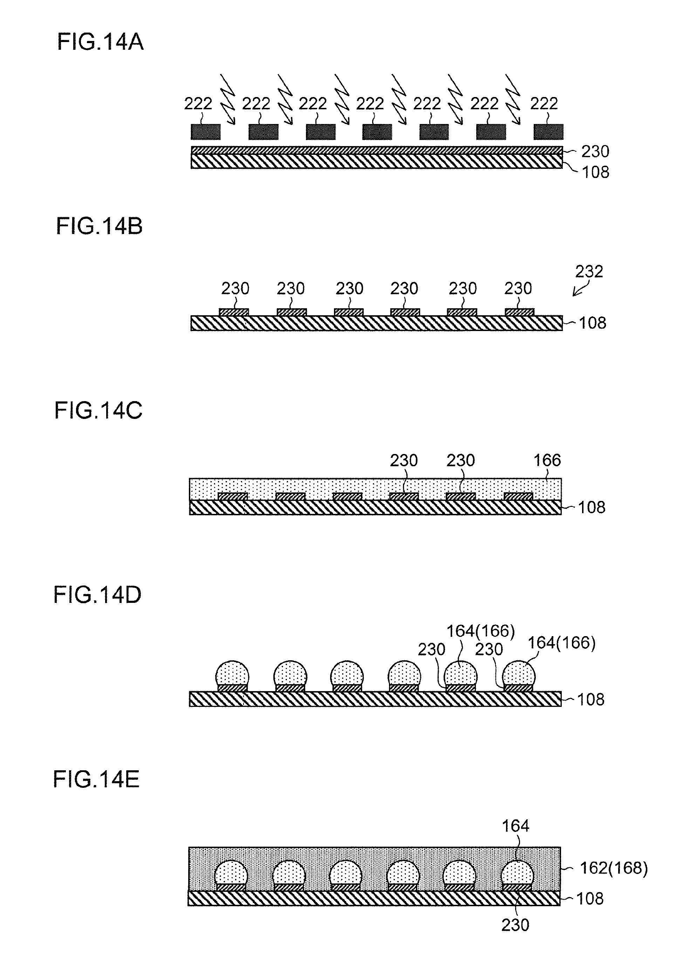

Fig. 13 is a flowchart of a manufacturing method of the ACF 160 illustrated in Fig. 10B, and Figs. 14A to 14E are cross-sectional views for explaining some steps in Fig. 13.

### «Step S21: Formation of Hydrophobic Film»

A hydrophobic material containing a surfactant is applied on the entire surface of the release sheet 108 having the same size as that of the ACF 160 to be manufactured, to form a hydrophobic film 230. Here, a material having the hydrophilic property is used for the release sheet 108.

The hydrophobic film 230 is then irradiated with UV light through a mask 222, and patterns on the mask 222 are transferred to the hydrophobic film 230 (see Fig. 14A). The mask 222 has the patterns of openings having the same shapes and the same pitch as those of the bottom surfaces of the conductive particle holding parts 164 to be formed.

### «Step S22: Development»

The hydrophobic film 230 to which the patterns have been transferred in the step S21 is developed and rinsed with pure water. Thereby, parts of the hydrophobic film 230 having been cured by the UV light form hydrophobic patterns 232, which have the same shapes and the same pitch as those of the bottom surfaces of the conductive particle holding parts 164 to be formed (see Fig. 14B).

Alternatively, the hydrophobic patterns 232 can be also formed by means of RIE.

### «Step S23: First Application of Resin Composition»

A resin composition 166 containing the conductive particles is applied on the top surface of the release sheet 108 on which the hydrophobic patterns 232 have been formed (see Fig. 14C). A method of providing a variation of the content rate of the conductive particles along the thickness direction of the ACF 160 can be the same as that of the ACF 150.

### «Step S24: Self-Organization of Resin Composition»

The resin composition 166 having been applied on the top surface of the release sheet 108 self-organizes to form truncated-spherical structures on the hydrophobic film 230 of the hydrophobic patterns 232.

### «Step S25: First Preliminary Curing»

The truncated-spherical structures formed by the self-organization of the resin composition 166 are preliminarily heated and cured. The resin composition 166 having been preliminarily heated and cured forms the conductive particle holding parts 164 (see Fig. 14D).

### «Step S26: Second Application of Resin Composition»

A structural adhesive resin composition 168 is applied on the top surfaces of the conductive particle holding parts 164 formed on the release sheet 108.

### «Step S27: Second Preliminary Curing»

Finally, the structural adhesive resin composition 168 is preliminarily heated and cured. The structural adhesive resin composition 168 having been preliminarily heated and cured forms the structural adhesive part 162 (see Fig. 14E).

According to the process as described above, it is possible to manufacture the ACF 160. The hydrophobic film 230 below the conductive particle holding part 164 does not remain on the ACF 160 but is removed along with the release sheet 108 when the release sheet 108 is peeled from the ACF 160. Further, even if some parts of the hydrophobic film 230 remain below the conductive particle holding part 164, the remaining hydrophobic film 230 is readily broken by the conductive particles upon compression bonding. Consequently, the hydrophobic film 230 does not affect the conductive connection through the ACF 160.

### <Manufacturing Method of ACF 170>

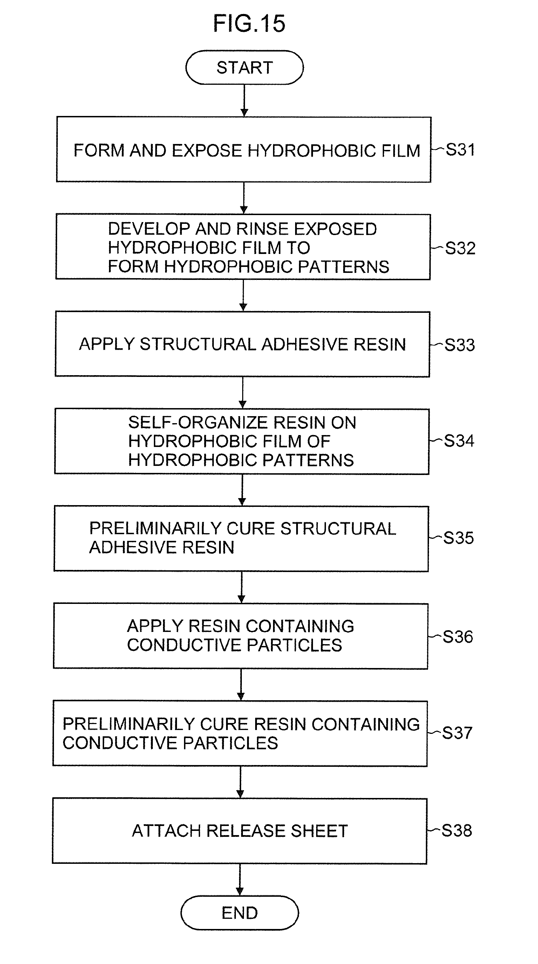

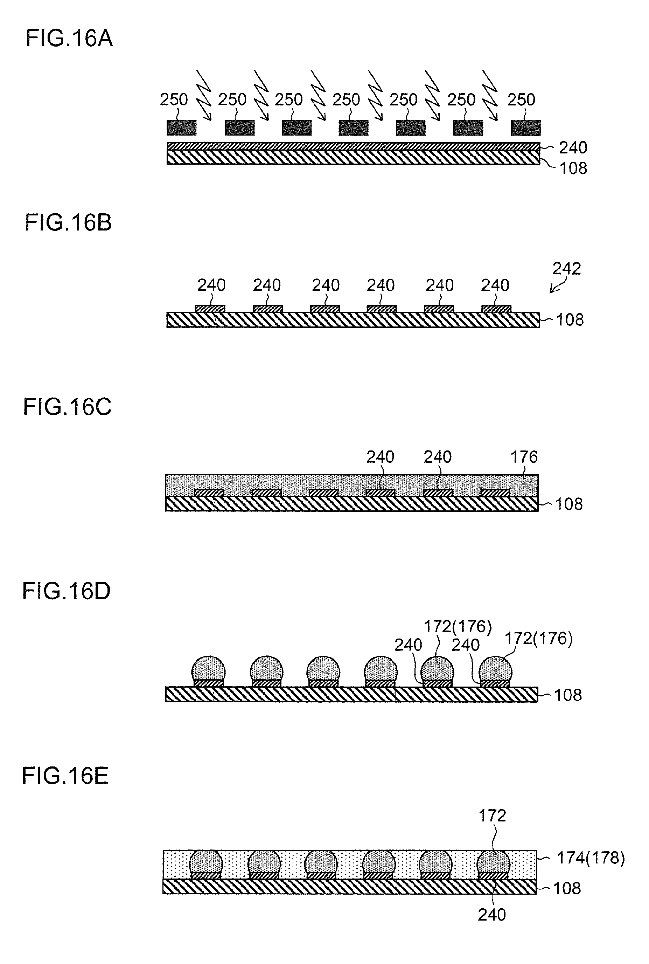

Fig. 15 is a flowchart of a manufacturing method of the ACF 170 illustrated in Fig. 10C, and Figs. 16A to 16E are cross-sectional views for explaining some steps in Fig. 15.

### «Step S31: Formation of Hydrophobic Film»

A hydrophobic material containing a surfactant is applied on the entire surface of the release sheet 108 having the same size as that of the ACF 170 to be manufactured, to form a hydrophobic film 240. Here, a material having the hydrophilic property is used for the release sheet 108.

The hydrophobic film 240 is then irradiated with UV light through a mask 250, and patterns on the mask 250 are transferred to the hydrophobic film 240 (see Fig. 16A). The mask 250 has the patterns of UV light blocking parts having the same shapes and the same pitch as those of the bottom surfaces of the conductive particle holding parts 174 to be formed.

### «Step S32: Development»

The hydrophobic film 240 to which the patterns have been transferred in the step S21 is developed and rinsed with pure water. Thereby, parts of the hydrophobic film 240 having been cured by the UV light form hydrophobic patterns 242. The hydrophobic patterns 242 define regions of the top surface of the release sheet 108 which are not covered with the cured hydrophobic film 240 and which have the same shapes and the same pitch as those of the bottom surfaces of the conductive particle holding parts 174 to be formed (see Fig. 16B).

Alternatively, the hydrophobic patterns 242 can be also formed by means of RIE.

### «Step S33: First Application of Resin Composition»

A structural adhesive resin composition 176 is applied on the top surface of the release sheet 108 on which the hydrophobic patterns 242 have been formed (see Fig. 16C).

### «Step S34: Self-Organization of Resin Composition»

The structural adhesive resin composition 176 having been applied on the top surface of the release sheet 108 self-organizes to form truncated-spherical structures on the hydrophobic film 240 of the hydrophobic patterns 242.

### «Step S35: First Preliminary Curing»

The truncated-spherical structures formed by the self-organization of the structural adhesive resin composition 176 are preliminarily heated and cured. The structural adhesive resin composition 176 having been preliminarily heated and cured forms the structural adhesive parts 172 (see Fig. 16D).

### «Step S36: Second Application of Resin Composition»

A resin composition 178 containing the conductive particles is applied on the top surface of the release sheet 108 on which the structural adhesive parts 172 have been formed. The conductive particle holding parts 174 to be formed of the resin composition 178 need to be independent (discrete) regions, and the resin composition 178 is applied at a certain amount such that the thickness of the applied resin composition 178 does not exceed the heights of the structural adhesive parts 172 having been formed. A method of providing a variation of the content rate of the conductive particles along the thickness direction of the ACF 170 can be the same as that of the ACF 150.

### «Step S37: Second Preliminary Curing»

The resin composition 178 containing the conductive particles is preliminarily heated and cured. The resin composition 178 having been preliminarily heated and cured forms the conductive particle holding parts 174 (see Fig. 16E).

### «Step S38: Attachment of Release Sheet»

Finally, the ACF 170 is finished by attaching the other release sheet 108 to the top surface.

According to the process as described above, it is possible to manufacture the ACF 170.

In the step S36, it is also possible to provide a variation of the content rate of the conductive particles along the thickness direction of the ACF 170 such that the conductive particle holding parts 174 hold a larger number of the conductive particles on the top side of the ACF 170. For example, it is possible that an adequate amount of the resin composition 178 of which the content rate of the conductive particles is relatively low or zero is applied before the resin composition 178 of which the content rate of the conductive particles is relatively high is applied, or it is also possible to draw the conducive particles upward by means of a magnetic force or an electrostatic force before preliminarily curing the resin composition 178. When the ACF 170 is thus manufactured, the side on which the content rate of the conductive particles is relatively high is used as the side for the mounting substrate (the pad side), and the side on which the content rate of the conductive particles is relatively low is used as the side for the IC (the bump side).

### Application to Inkjet Head

The ACFs according to the above-described embodiments can be used, for example, to mount ICs onto circuit substrates around inkjet heads. In particular, in an inkjet recording apparatus which uses an aqueous ink, the inkjet heads and the surroundings are exposed to humid environment, and therefore, it is necessary to improve moisture resistance of the mounting substrates of, for example, driving ICs of the inkjet heads. The ACFs according to the above-described embodiments are provided with the improved moisture resistance by using the resin compositions containing the inorganic fillers, and are suitable for the mounting substrates around the inkjet heads.

It should be understood that there is no intention to limit the invention to the specific forms disclosed, but on the contrary, the invention is to cover all modifications, alternate constructions and equivalents falling within the scope of the invention as expressed in the appended claims.

## Claims

1. An anisotropic conductive film (100, 110, 120, 130, 140, 150, 160, 170), comprising:
an insulation region (102, 122, 132, 142, 12, 162, 172) having a planer shape and containing an insulating filler (107) at a first content rate; and
a plurality of conductive particle holding regions (104, 124, 134, 144, 154, 164, 174) arranged in the insulation region, the conductive particle holding regions holding conductive particles (106) and containing the insulating filler at a second content rate lower than the first content rate, the conductive particle holding regions being arranged discretely in a planar direction of the insulation region.

2. The anisotropic conductive film as defined in claim 1, wherein the anisotropic conductive film is arranged between a first member (22) provided with a first terminal (24) and a second member (32) provided with a second terminal (36) and is compressed in a thickness direction of the insulation region to bond the first member and the second member through the insulation region and to electrically connect the first terminal and the second terminal through the conductive particles.

3. The anisotropic conductive film as defined in claim 1 or 2, wherein the insulation region has a viscosity higher than a viscosity of the conductive particle holding regions.

4. The anisotropic conductive film as defined in any of claims 1 to 3, wherein the insulation region includes a structural adhesive.

5. The anisotropic conductive film as defined in claim 4, wherein the structural adhesive uses a thermal cross-linking reaction.

6. The anisotropic conductive film as defined in any of claims 1 to 5, wherein each of the conductive particle holding regions has a variation of a content rate of the conductive particles along a thickness direction of the insulation region.

7. The anisotropic conductive film as defined in claim 6, wherein in each of the conductive particle holding regions, the content rate of the conductive particles on a bottom side is higher than the content rate of the conductive particles on a top side.

8. The anisotropic conductive film as defined in any of claims 1 to 7, wherein each of the conductive particle holding regions has an exposed surface in at least one of a top surface and a bottom surface of the insulation region.

9. The anisotropic conductive film as defined in claim 8, wherein each of the conductive particle holding regions has one of a columnar shape, a circular truncated cone shape, a conical shape, a spool shape, a semispherical shape and a truncated spherical shape, of which a base is the exposed surface.

10. The anisotropic conductive film as defined in any of claims 1 to 9, wherein each of the conductive particle holding regions contains the conductive particles at a concentration of 30000 particles/mm² to 60000 particles/mm².

11. The anisotropic conductive film as defined in any of claims 1 to 10, wherein each of the conductive particles consists of metal.

12. The anisotropic conductive film as defined in any of claims 1 to 10, wherein each of the conductive particles has a core-shell structure of a resin nucleus (106a) covered with metal (106b).

13. The anisotropic conductive film as defined in any of claims 1 to 12, wherein the insulating filler includes silica.

14. The anisotropic conductive film as defined in any of claims 1 to 13, wherein the conductive particle holding regions are arranged at a fixed pitch along an X direction and a Y direction perpendicular to the X direction, the X direction and the Y direction being parallel to the planar direction of the insulation region.

15. A method of making conductive connection between a first terminal arranged on a first member and a second terminal arranged on a second member, the method comprising the steps of:
temporarily tacking the anisotropic conductive film as defined in any of claims 1 to 14 to the first member;
then holding the first member and the second member such that the first terminal and the second terminal face to each other across the temporarily tacked anisotropic conductive film;
then pressing the first member and the second member to each other; and
then heating the anisotropic conductive film.
